# FASCICULE DE BREVET EUROPEEN

(11) **EP 2 576 866 B1**
(45) Date de publication et mention de la délivrance du brevet: **19.03.2014**
(21) Numéro de dépôt: 11727240.1
(22) Date de dépôt: 19.05.2011
(51) Int. Cl.: C23C 30/00, C23C 28/00, C23C 16/56, C23C 16/40, C23C 14/58, C23C 14/18

(54) **Procédé de diffusion de particules métalliques au sein d'une couche composite**
VERFAHREN ZUR DIFFUSION VON METALLPARTIKELN INNERHALB EINER VERBUNDSCHICHT
METHOD FOR DIFFUSING METAL PARTICLES WITHIN A COMPOSITE LAYER

(30) Priorité: 02.06.2010 FR 1054311
(43) Date de publication de la demande: 10.04.2013
(73) Titulaire: Commissariat à l'Énergie Atomique et aux Énergies Alternatives, 75015 Paris (FR); Centre National de la Recherche Scientifique, 75016 Paris (FR)
(72) Inventeur: BEDEL, Laurent, F-38950 Quaix En Chartreuse (FR); CAYRON, Cyril, F-38100 Grenoble (FR); JOUVE, Michel, F-38430 Moirans (FR); MAURY, Francis, F-31670 Labege (FR); QUESNEL, Etienne, F-38240 Meylan (FR)
(74) Mandataire: Vuillermoz, Bruno
(86) Numéro de dépôt international: PCT/FR2011/051145
(87) Numéro de publication internationale: WO 2011/151561

(56) Documents cités:
- YLINIEMI K ET AL: "Chemical composition and barrier properties of Ag nanoparticle-containing sol-gel films in oxidizing and reducing low-temperature plasmas", SURFACE AND COATINGS TECHNOLOGY, ELSEVIER, AMSTERDAM, NL, vol. 201, no. 18, 25 juin 2007 (2007-06-25), pages 7865-7872, XP025317804, ISSN: 0257-8972, DOI: DOI:10.1016/J.SURFCOAT.2007.03.023 [extrait le 2007-05-25]
- ARMELAO L ET AL: "Recent trends on nanocomposites based on Cu, Ag and Au clusters: A closer look", COORDINATION CHEMISTRY REVIEWS, ELSEVIER SCIENCE, AMSTERDAM, NL, vol. 250, no. 11-12, 1 juin 2006 (2006-06-01), pages 1294-1314, XP025166222, ISSN: 0010-8545, DOI: DOI:10.1016/J.CCR.2005.12.003 [extrait le 2006-06-01]
- GARCÍA M ET AL: "Photoluminescence of silver in glassy matrices", JOURNAL OF APPLIED PHYSICS, AMERICAN INSTITUTE OF PHYSICS. NEW YORK, US, vol. 96, no. 7, 1 janvier 2004 (2004-01-01), pages 3737-3741, XP012068983, ISSN: 0021-8979, DOI: DOI:10.1063/1.1778473
- TORRELL M ET AL: "Functional and optical properties of Au:TiO2 nanocomposite films: The influence of thermal annealing", APPLIED SURFACE SCIENCE, ELSEVIER, AMSTERDAM, NL, vol. 256, no. 22, 20 avril 2010 (2010-04-20), pages 6536-6542, XP027092467, ISSN: 0169-4332 [extrait le 2010-04-20]
- OVCHINNIKOV V ET AL: "Surface Plasmon Resonances in Diffusive Reflection Spectra of Multilayered Silver Nanocomposite Films", QUANTUM, NANO AND MICRO TECHNOLOGIES, 2008 SECOND INTERNATIONAL CONFERENCE ON, IEEE, PISCATAWAY, NJ, USA, 10 février 2008 (2008-02-10), pages 40-44, XP031232994, ISBN: 978-0-7695-3085-7

## Description

### DOMAINE DE L'INVENTION

La présente invention concerne un procédé de diffusion de particules métalliques dans une couche composite comprenant une matrice diélectrique et lesdites particules métalliques.

Les domaines d'application de la présente invention comprennent notamment la microélectronique, le photovoltaïque, l'optique, la catalyse, les capteurs.

### ETAT ANTERIEUR DE LA TECHNIQUE

Les couches minces, ou matrices, comprenant des particules métalliques et notamment des nanoparticules métalliques possèdent des caractéristiques spécifiques à leurs structure et composition. Selon le cas, ces couches composites peuvent ainsi présenter des propriétés électriques, catalytiques, optiques ou magnétiques par exemple.

Afin d'envisager diverses applications, notamment dans les domaines suscités, il est important de pouvoir contrôler la structure de ces couches minces comprenant des particules métalliques pour anticiper les propriétés finales. Par exemple, les couches composites peuvent présenter un effet de résonnance plasmon de surface renforçant l'absorption de la lumière et influençant ainsi le rendement d'une cellule photovoltaïque. Il existe donc un besoin évident de contrôler les caractéristiques de la couche composite.

Ces couches composites peuvent être obtenues par un procédé de dépôt de composite sur un substrat. Le dépôt est généralement réalisé selon des techniques connues de l'homme du métier, à savoir soit par voie humide (imprégnation, sol-gel) soit par voie sèche (PVD, CVD).

Le dépôt par PVD (selon l'acronyme anglo-saxon « *Physical Vapor Deposition* ») est un dépôt physique en phase vapeur par évaporation sous vide alors que le dépôt par CVD (selon l'acronyme anglo-saxon « *Chemical Vapor Deposition* ») est un dépôt chimique en phase vapeur.

Les couches composites ainsi obtenues peuvent présenter une structure homogène ou multicouche selon le mode de préparation utilisé.

Lorsque la matrice et les particules métalliques sont déposées simultanément, ces dernières sont noyées dans la matrice laissant un faible taux affleurer la surface de la matrice. Un tel dépôt est homogène, notamment dans l'épaisseur du film ou de la couche mince.

En revanche, lorsque le dépôt est réalisé en plusieurs étapes distinctes et successives, une architecture multicouche est obtenue. Dans cette architecture, aussi appelée structure « sandwich », le dépôt de la matrice et le dépôt des particules métalliques sont réalisés séquentiellement. Ainsi, les particules métalliques peuvent être isolées au sein de la matrice si la couche finale consiste en un dépôt de matrice.

Bien que ces deux procédés demeurent bien distincts l'un de l'autre et que les dépôts ainsi obtenus présentent chacun leurs propres caractéristiques, les particules métalliques peuvent évoluer dans les deux cas. Elles peuvent changer de taille, de forme et diffuser pendant le procédé d'élaboration. Le contrôle de la structure de la couche composite et donc de ses propriétés devient ainsi très aléatoire, notamment en termes de reproductibilité.

Il est établi qu'un post traitement de couches composites permet de modifier ou de contrôler la forme, la taille et la répartition des particules. Il devient ainsi envisageable de contrôler les caractéristiques et propriétés finales des couches composites.

L'art antérieur comporte plusieurs solutions mettant en oeuvre un post traitement. Pivin et al. ont montré que la forme ainsi que la taille de nanoparticules métalliques pouvaient être modifiées par irradiation ionique (« Competing processes of clustering and mixing of noble metal film embedded in silica under ion irradiation », J.C. Pivin, G. Rizza, Thin Solid Films, Vol. 366, pp. 284-293, 2000).

Teeng et al. ont décrit la préparation d'une couche de nanocomposites TaN-Ag par co-pulvérisation. Le contrôle de la croissance des nanoparticules d'argent est assuré par un recuit ("Rapid Thermal Annealing") (« Microstructural analysis and mechanical properties of TaN-Ag nanocomposite », C.C. Tseng, J.H. Hsieh, S.C. Jang, Y.Y. Chang, W. Wu, Thin Solid Films, Vol. 517, pp. 4970-4974, 2009).

L'absorption optique des plasmons de surface après un recuit opéré entre 400 et 800 °C de films composites SiO₂-Ag-Au déposés par co-pulvérisation a été étudiée par Sangpour et al. (« The effect of Au/Ag ratios on surface composition and optical properties of co-sputtered alloy nanoparticles in Au-Ag-SiO2 thin film », P. Sangpour, O. Akhavan, A.Z. Moshfegh, Journal of Alloys and Compounds, Vol. 486, pp. 22-28, 2009). Il a été observé que le recuit entraine la diffusion des éléments métalliques, la formation de nanoparticules métalliques étant détectée par absorption optique.

Par ailleurs, Wang et al. ont décrit la photodiffusion de particules d'argent déposées sur du GeS sous lampe Xe (« Photodiffusion of silver in germanium-sulfur compounds studied by AFM, nanoindentation and RBS methods », R. Wang, J.H. Horton, Physical Chemistry Chemical Physics, Vol.5, pp.4335-4342, 2003). Cependant, ce document ne fait pas état de la présence de nanoparticules.

La présente invention concerne notamment un procédé de diffusion de particules métalliques dans une couche composite, à température ambiante et à pression réduite, permettant le contrôle de la structure de la couche composite formée par les particules métalliques et une matrice diélectrique.

### EXPOSE DE L'INVENTION

Le Demandeur a mis au point un procédé permettant la diffusion de particules métalliques, dans lequel la couche composite préalablement déposée sur un substrat est soumise à un post-traitement. L'étape de post-traitement permet de contrôler la diffusion des particules métalliques.

Par diffusion, on entend tout mécanisme de transport d'au moins une espèce métallique dans une matrice ou vers le substrat.

Plus précisément, la présente invention concerne un procédé de diffusion de particules métalliques comprises dans une couche composite préalablement déposée sur un substrat, ladite couche composite comprenant en outre au moins une matrice diélectrique, dans lequel la diffusion desdites particules métalliques vers ledit substrat est réalisée à l'aide d'un traitement plasma.

En d'autres termes, l'invention consiste notamment à utiliser un plasma au voisinage d'un substrat recouvert d'au moins un dépôt matrice-particules métalliques afin de contrôler la diffusion des particules métalliques au sein de la matrice ou vers le substrat. Le procédé selon l'invention permet ainsi de contrôler l'intensité de l'absorption optique due à la résonance des plasmons de surface des particules métalliques.

L'invention a donc principalement pour objet l'utilisation d'un plasma au voisinage d'un substrat comportant une couche composite pour faire diffuser les particules métalliques de la couche composite en direction du substrat.

Le substrat sert généralement de couche barrière à la diffusion.

Comme déjà indiqué, la couche composite peut être préparée :
- par dépôt simultané des particules métalliques et de la matrice diélectrique, ou
- par dépôts séquentiels d'au moins une matrice diélectrique et des particules métalliques.

Dans le premier cas, la matrice et les particules métalliques sont déposées simultanément, ces dernières sont dispersées dans la matrice diélectrique laissant un faible taux affleurer la surface de la matrice. Un tel dépôt est homogène, notamment dans l'épaisseur du film ou de la couche mince.

Lorsque la couche composite est préparée par dépôts séquentiels de la matrice diélectrique et des particules métalliques, le dépôt est réalisé en plusieurs étapes distinctes et successives. Une architecture multicouche, aussi appelée structure sandwich, est ainsi obtenue. Eventuellement, les particules métalliques peuvent être isolées au sein de la matrice si la couche finale consiste en un dépôt de matrice diélectrique.

De manière avantageuse, le traitement plasma est réalisé à l'aide d'un plasma dit plasma froid et encore plus avantageusement, sous l'effet d'un plasma froid proche de ou à la température ambiante. Il est également nécessaire qu'aucun précurseur chimique, de nature à se décomposer, ne soit introduit dans le plasma.

De manière générale, le traitement plasma est avantageusement réalisé entre 15 °C et 45 °C. Ainsi, le procédé selon l'invention présente l'avantage de pouvoir être appliqué à des substrats de nature diverse et notamment à ceux étant thermiquement sensibles.

Typiquement, le plasma utilisé dans le procédé de diffusion de particules métalliques selon la présente invention contient au moins un gaz, qui est, de manière préférentielle, choisi dans le groupe comprenant l'hélium, l'argon, le xénon ou un mélange de ces gaz.

Bien entendu, les conditions de température et de pression ainsi que la nature des gaz constituant le plasma sont adaptées selon les cas. Par exemple, l'homme du métier pourra aisément ajuster la pression en fonction du gaz utilisé. Dans le cas de l'hélium, la pression du réacteur est typiquement de l'ordre de 26 Pa.

Dans un mode de réalisation bien particulier, le traitement plasma peut être réalisé :
- dans un réacteur PECVD,
- avec de l'hélium,
- avec une fréquence comprise entre 0 et 2,45 GHz, de préférence entre 10kHz et 450 kHz,
- pendant une durée comprise entre 1 seconde et 60 minutes, avantageusement entre 15 secondes et 15 minutes,
- avec une puissance appliquée sur la cathode comprise entre 0,01 W/cm² et 10 W/cm², en particulier entre 0,01 W/cm² et 1 W/cm²,
- à une température comprise entre 15 et 45 °C.

De façon avantageuse, le plasma peut être généré par une alimentation DC, basse fréquence, RF, MW, ou ECR.

De manière générale, la couche composite est réalisée selon les techniques connues de l'homme du métier, soit par voie humide (imprégnation, sol-gel), soit par voie sèche (PVD, CVD), plus avantageusement par PVD.

On précisera simplement que le dépôt par PVD est un dépôt par évaporation sous vide alors que le dépôt par CVD est un dépôt chimique en phase vapeur.

Le dépôt simultané de la matrice et des particules métalliques permet d'obtenir une couche composite homogène, alors que les dépôts par étapes distinctes et successives de la matrice et des particules métalliques donnent une structure sandwich.

La matrice diélectrique est avantageusement un oxyde diélectrique, et encore plus avantageusement de l'oxyde de silicium SiOₓ.

Comme déjà indiqué, la couche composite déposée sur le substrat avant traitement plasma, est principalement constituée d'une matrice sous forme d'une couche mince, et de particules métalliques. Le substrat est typiquement en verre, en silicium ou en polymère.

D'autre part, les particules métalliques sont avantageusement des particules d'un métal choisi dans le groupe comprenant l'argent, le cuivre, l'or, le titane, le chrome, le tantale, ou un mélange de ces métaux. Les particules métalliques se présentent, de manière préférentielle, sous forme de nanoparticules dont la plus grande dimension est inférieure à 100 nm.

De manière générale, la plus grande dimension des particules métalliques est inférieure à 1 micromètre, de préférence inférieure à 100 nm.

La présente invention concerne également l'utilisation d'un plasma au voisinage d'un substrat sur lequel est préalablement déposée une couche composite intégrant des particules métalliques pour réaliser la diffusion desdites particules métalliques en direction du substrat.

Comme déjà indiqué, la couche composite est constituée soit d'une matrice diélectrique dans laquelle sont dispersées les particules métalliques, soit d'une matrice diélectrique sur laquelle sont déposées les particules métalliques.

Le procédé selon l'invention présente les avantages d'être peu coûteux et d'être réalisable à température ambiante. Il permet de contrôler l'effet de plasmon de surface en fonction du temps d'exposition au plasma hélium.

Il permet en outre de moduler les propriétés fonctionnelles de la couche composite en maîtrisant la diffusion des particules métalliques vers le substrat.

### DESCRIPTION DES FIGURES

L'invention et les avantages qui en découlent ressortiront mieux des exemples de réalisation qui suivent, donnés à titre indicatif et non limitatif à l'appui des figures annexées, dans lesquelles :
- la figure 1 représente un schéma de principe du réacteur de post traitement plasma ;
- la figure 2 illustre un dépôt SiOₓ-Ag-SiOₓ sur une grille MET (microscopie électronique en transmission) ;
- la figure 3 représente les courbes de transmission en fonction de la longueur d'onde obtenues pour un substrat en verre revêtu d'un dépôt sandwich SiOₓ-Ag-SiOₓ avant et après post-traitement par un plasma He ; la courbe (a) illustre le dépôt avant post-traitement alors que les courbes (b) à (e) illustrent le dépôt après un post-traitement de 30 secondes, 2 minutes, 5 minutes et 10 minutes respectivement ;
- la figure 4 représente une vue en coupe du dépôt SiOₓ-Ag-SiOₓ sur une grille MET. Cette figure illustre l'accumulation des particules d'argent à l'interface SiOx et silice du substrat après traitement plasma.
- la figure 5 illustre un dépôt SiOₓ-Ag-SiOₓ sur une grille MET mais avec une quantité d'argent inférieure à celle utilisée dans l'exemple 1 de la figure 2 ;
- la figure 6 représente les courbes de transmission en fonction de la longueur d'onde obtenues pour un substrat en verre revêtu d'un dépôt sandwich SiOₓ-Ag-SiOₓ (exemple 2) avant et après post-traitement par un plasma He ; la courbe (a) illustre le dépôt avant post-traitement alors que les courbes (b) à (d) illustrent le dépôt après un post-traitement de 30 secondes, 2 minutes et 5 minutes respectivement ;
- la figure 7 représente le profil de concentration en argent en fonction du temps.

### EXEMPLES DE REALISATION

La préparation des échantillons des exemples 1 à 3 est réalisée à température ambiante.

Le dépôt par PECVD (« *Plasma-Enhanced Chemical Vapor Deposition* ») est un dépôt chimique en phase vapeur assisté par plasma.

### Exemple 1

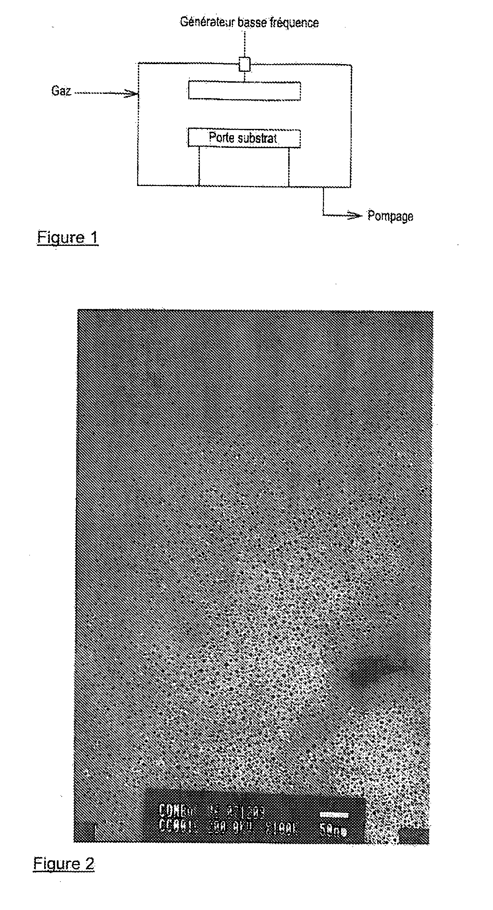

Cet exemple est illustré par les figures 2 à 4.

Une couche composite SiOₓ-Ag-SiOₓ est déposée sur un substrat de verre sodocalcique, un substrat de silicium et sur une grille pour observation MET (microscopie électronique en transmission).

Ce dépôt est réalisé en trois étapes comprenant :
- le dépôt d'une première couche de SiOₓ par PECVD basse fréquence ; l'échantillon de verre, MET ou Si est déposé sur un porte-substrat relié à la masse ; une cathode en aluminium est positionnée à une distance de 3,5 cm du substrat ; un mélange gazeux He et HMDSO, hexaméthyldisiloxane (1%), est introduit dans le réacteur, la pression est régulée à 26 Pa ; la puissance appliquée sur la cathode est de 2 W.cm⁻² avec une fréquence de 40 kHz pendant 10 secondes ; la phase gazeuse réactive est décomposée par le plasma ; l'épaisseur du dépôt, noté SiOₓ est d'environ 30 nanomètres.
- le dépôt de nanoparticules d'argent selon les techniques de l'art antérieur (FR 2924359) ; l'échantillon est ensuite placé dans un réacteur de pulvérisation cathodique magnétron à une distance de 3 cm de la cible d'argent ; de l'argon est introduit dans le réacteur et la pression de travail est fixée à 26 Pa ; le générateur utilisé pour pulvériser la cible d'argent est un générateur à courant pulsé (100 kHz) avec une densité de puissance de 1 W.cm⁻². La durée du dépôt est de 7 secondes.
- le dépôt d'une deuxième couche de SiOₓ réalisé de manière identique au dépôt de la première couche de SiOₓ.

### Caractéristiques du film obtenu :

Le film ou couche composite ainsi obtenu a une architecture sandwich SiOₓ-nanoparticules d'argent-SiOₓ. Ce dépôt sandwich a été réalisé sur une grille MET en cuivre recouverte d'un film de carbone. L'observation en transmission du film sandwich au MET révèle la présence de nanoparticules d'argent d'environ 3 nanomètres de diamètre.

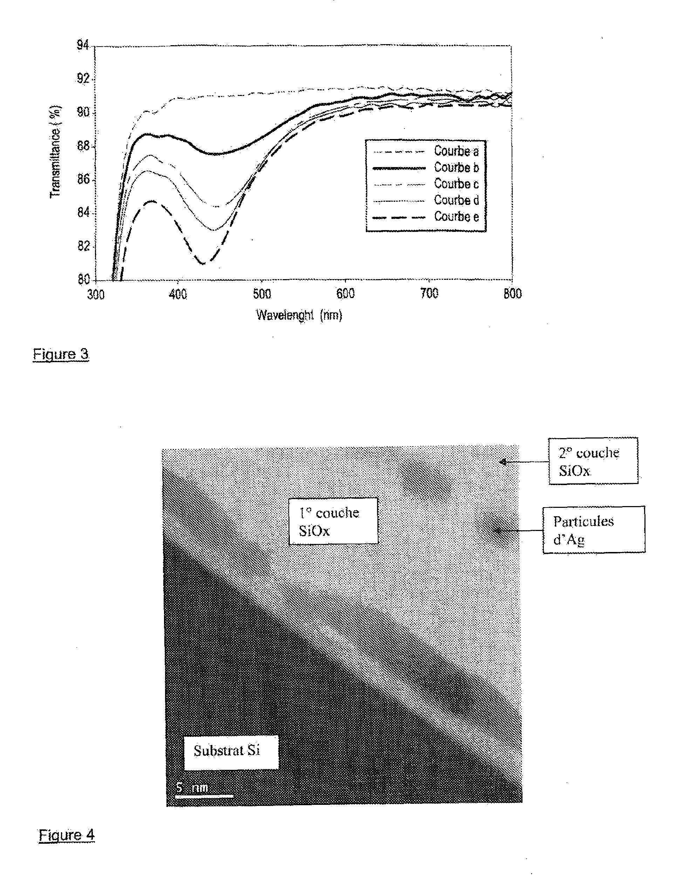

La transmittance du film déposé sur du verre sodocalcique est déterminée par une mesure au spectromètre optique entre 300 et 800 nanomètres. La courbe de transmission (figure 3 courbe (a)) est identique à celle qui est classiquement observée pour une lame sodocalcique avec une forte absorption en dessous de 400 nanomètres qui est due au verre lui-même. La transmittance au-delà de 400 nanomètres est d'environ 91 %. Il n'y a pas de signature spécifique au dépôt qui est donc transparent dans le visible.

### Application d'un post-traitement sur l'échantillon déposé sur verre :

L'échantillon de verre est placé dans le réacteur de post-traitement et dans ce cas, seul de l'hélium est introduit dans le réacteur.

La pression est régulée à 26 Pa. La puissance appliquée sur la cathode est seulement de 0,13 W.cm⁻². La fréquence est maintenue à 40 kHz.

Des mesures de transmittance sur un échantillon de verre revêtu du dépôt sandwich SiOₓ-nanoparticules d'argent-SiOₓ ont été effectuées après un post-traitement sous plasma hélium d'une durée totale de 30 secondes, 2 minutes, 5 minutes et 10 minutes.

Avec le post-traitement, on détecte un pic d'absorption centré sur une gamme de longueurs d'onde de 420 - 450 nanomètres. Cette absorption est caractéristique d'une résonance des plasmons de surface des nanoparticules d'argent dans une matrice SiO₂. L'intensité de cette bande d'absorption croît avec la durée du post-traitement plasma He. Le contrôle de l'absorption est alors fonction du temps d'exposition au plasma hélium.

Avec le post traitement, une accumulation de particules d'argent est détectée lors des observations en coupe sur le substrat de silicium (figure 4). La diffusion est stoppée par la silice native qui fait office de couche barrière à la diffusion.

### Exemple 2

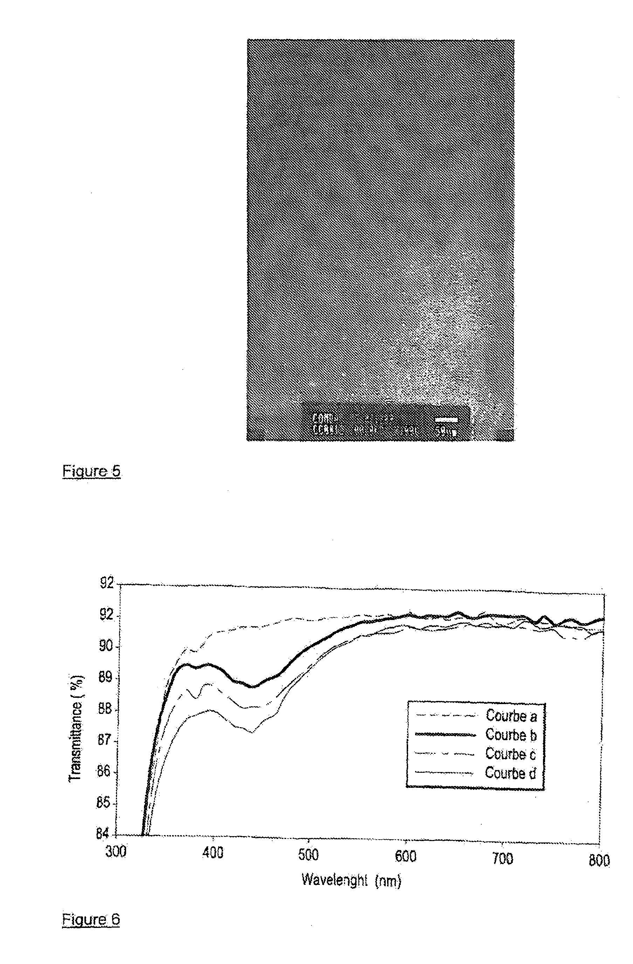

Cet exemple est illustré par les figures 5 et 6.

Un dépôt SiOₓ-nanoparticules d'argent-SiOₓ est déposé en trois étapes sur un substrat de verre sodocalcique et sur une grille pour observation MET, avec une quantité d'argent plus faible que dans l'exemple 1.

La première et la troisième étape sont identiques à celles de l'exemple 1. La deuxième étape se différencie par la densité de puissance injectée sur la cible d'argent. Dans cet exemple, elle est de 0,5 W.cm⁻², soit deux fois moins importantes que dans l'exemple 1.

### Caractéristiques du film obtenu :

Comme pour l'exemple 1, le dépôt final a une structure sandwich SiOₓ-nanoparticules d'argent-SiOₓ. L'observation en transmission du film sandwich au MET sur un échantillon de grille MET en cuivre révèle la présence de nanoparticules d'argent d'environ 1,5 nanomètre de diamètre. Ces nanoparticules d'argent sont environ deux fois plus petites que celles obtenues dans l'exemple 1.

La transmittance du film déposé sur du verre sodocalcique est déterminée par une mesure au spectromètre optique entre 300 et 800 nanomètres. La courbe (a) de transmission (figure 6) correspond à la transmission de l'échantillon de verre tel que déposé (avant post-traitement). Elle est similaire à la courbe (a) de la figure 3, elle-même quasiment identique à celle du substrat de verre vierge. Le dépôt est transparent dans le visible.

### Application d'un post-traitement sur l'échantillon déposé sur verre :

De la même façon que dans l'exemple 1, l'échantillon est placé dans le réacteur PECVD. De l'hélium est introduit et la pression est régulée à 26 Pa. La puissance appliquée sur la cathode est de 0,13 W.cm⁻². La fréquence est maintenue à 40 kHz.

Des mesures de transmittance sur un échantillon de verre revêtu du dépôt de SiOₓ-nanoparticules d'argent-SiOₓ ont été effectuées après un post-traitement sous plasma hélium d'une durée totale de 30 secondes, 2 minutes et 5 minutes. Les courbes de transmittance sont représentées sur la figure 6.

Avec le post-traitement, on retrouve un pic d'absorption centré sur une gamme de longueur d'onde de 420 - 450 nanomètres. L'intensité de l'absorption est plus faible que dans l'exemple 1, ce qui est logique car il y a moins d'argent dans cet échantillon puisque la densité de puissance appliquée sur la cible d'argent était deux fois plus faible par rapport à l'exemple 1. Mais l'absorption croît aussi avec le temps d'exposition au plasma hélium et la coloration de l'échantillon s'intensifie.

Le deuxième exemple démontre à nouveau l'efficacité du post traitement par un plasma hélium pour contrôler la résonnance des plasmons de surface des nanoparticules métalliques.

### Exemple 3

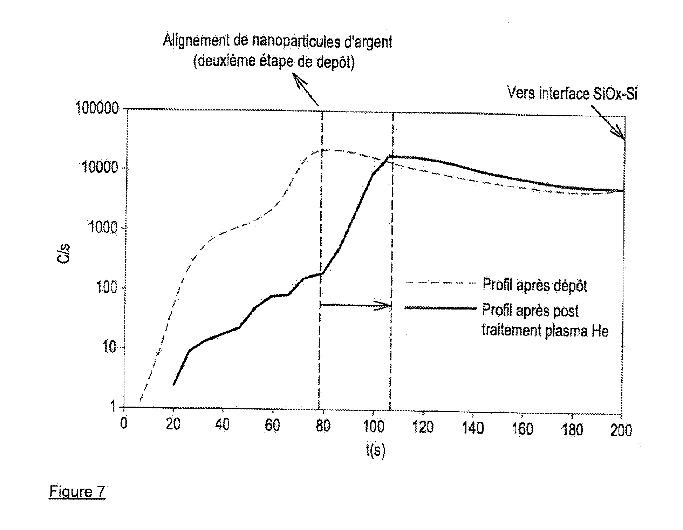

Cet exemple est illustré par la figure 7.

Un dépôt SiOₓ-Ag-SiOₓ est déposé en trois étapes sur plusieurs substrats de silicium.

Deux échantillons de silicium sont revêtus dans les mêmes conditions que dans l'exemple 1. Sur le premier échantillon, un profil SIMS (Spectrométrie de masse à ionisation secondaire ou « *Secondary Ion Mass Spectrometry* ») d'argent est réalisé juste après le dépôt. Sur le deuxième échantillon, un post-traitement sous plasma d'hélium de 10 minutes avec des conditions identiques à celles des exemples 1 et 2 est appliqué, puis le profil SIMS d'argent est déterminé. Les conditions d'analyse au SIMS sont identiques au premier échantillon.

Après dépôt, des particules d'argent sont présentes dans les deux couches de SiOₓ (première et troisième étapes de dépôt). Après le post-traitement sous plasma Hélium, ce profil est modifié. Il apparaît clairement une diffusion des particules d'argent vers le substrat de silicium. La quantité de particules d'argent est plus faible dans la deuxième couche SiOₓ qui est en surface externe de l'échantillon (troisième étape de dépôt) et le maximum de concentration en argent est décalé vers le substrat.

Il en résulte un avantage supplémentaire de l'invention, résidant dans la possibilité de contrôler la diffusion des particules d'argent vers le substrat et donc de moduler les propriétés fonctionnelles.

## Revendications

1. Procédé de diffusion de particules métalliques comprises dans une couche composite préalablement déposée sur un substrat, ladite couche composite comprenant en outre au moins une matrice diélectrique, dans lequel la diffusion desdites particules métalliques vers ledit substrat est réalisée à l'aide d'un traitement plasma.

2. Procédé de diffusion de particules métalliques selon la revendication 1, ***caractérisé* en ce que** le traitement plasma est réalisé à l'aide d'un plasma dit plasma froid, avantageusement à l'aide d'un plasma froid à température ambiante.

3. Procédé de diffusion de particules métalliques selon l'une des revendications 1 et *2,* ***caractérisé* en ce que** le plasma contient au moins un gaz choisi dans le groupe comprenant l'hélium, l'argon, le xénon ou un mélange de ces gaz.

4. Procédé de diffusion de particules métalliques selon l'une des revendications précédentes, ***caractérisé* en ce que** les particules métalliques sont des particules d'un métal choisi dans le groupe comprenant l'argent, le cuivre, l'or, le titane, le chrome, le tantale, ou un mélange de ces métaux, et se présentent avantageusement sous la forme de nanoparticules.

5. Procédé de diffusion de particules métalliques selon l'une des revendications précédentes, ***caractérisé* en ce que** la couche composite est préparée :
- par dépôt simultané des particules métalliques et de la matrice diélectrique, ou
- par dépôts séquentiels d'au moins une matrice diélectrique et des particules métalliques.

6. Procédé de diffusion de particules métalliques selon l'une des revendications précédentes, ***caractérisé* en ce que** la matrice diélectrique est une couche composite préparée par voie humide (imprégnation, sol-gel) ou par voie sèche (PVD, CVD), avantageusement par PVD.

7. Procédé de diffusion de particules métalliques selon l'une des revendications précédentes, ***caractérisé* en ce que** la matrice diélectrique est un oxyde diélectrique, plus avantageusement de l'oxyde de silicium, SiOₓ.

8. Procédé de diffusion de particules métalliques selon l'une des revendications précédentes, ***caractérisé* en ce que** le substrat est en verre, en silicium ou en polymère.

9. Procédé de diffusion de particules métalliques selon l'une des revendications précédentes, ***caractérisé* en ce que** le traitement plasma est réalisé :
- dans un réacteur PECVD,
- avec de l'hélium,
- avec une fréquence comprise entre 0 et 2,45 GHz, de préférence entre 10kHz et 450 kHz,
- pendant une durée comprise entre 1 seconde et 60 minutes, de préférence entre 15 secondes et 15 minutes,
- avec une puissance appliquée sur la cathode comprise entre 0,01 W/cm² et 10 W/cm², en particulier entre 0,01 W/cm² et 1 W/cm²,
- à une température comprise entre 15 et 45 °C.

10. Utilisation d'un plasma au voisinage d'un substrat sur lequel est préalablement déposée une couche composite intégrant des particules métalliques pour réaliser la diffusion desdites particules métalliques en direction du substrat.

11. Utilisation d'un plasma selon la revendication 10, selon laquelle la couche composite est constituée d'une matrice diélectrique dans laquelle sont dispersées les particules métalliques.

12. Utilisation d'un plasma selon la revendication 10, selon laquelle la couche composite est constituée d'une matrice diélectrique sur laquelle sont déposées les particules métalliques.

## Patentansprüche

1. Verfahren zur Diffusion von Metallpartikeln, die in einer zuvor auf einem Substrat abgeschiedenen Verbundschicht eingeschlossen wurden, wobei die Verbundschicht darüber hinaus mindestens eine dielektrische Matrix umfasst, bei dem die Diffusion der Metallpartikel zum Substrat mittels einer Plasmabehandlung erfolgt.

2. Verfahren zur Diffusion von Metallpartikeln nach Anspruch 1, **dadurch gekennzeichnet, dass** die Plasmabehandlung mittels eines als Kaltplasma bezeichneten Plasmas, vorteilhafter Weise mittels eines Kaltplasmas mit Umgebungstemperatur erfolgt.

3. Verfahren zur Diffusion von Metallpartikeln nach einem der Ansprüche 1 und 2, **dadurch gekennzeichnet, dass** das Plasma mindestens ein Gas enthält, das aus der Gruppe ausgewählt ist, die Helium, Argon, Xenon oder ein Gemisch dieser Gase umfasst.

4. Verfahren zur Diffusion von Metallpartikeln nach einem der vorhergehenden Ansprüche, **dadurch gekennzeichnet, dass** die Metallpartikel Partikel eines Metalls sind, die aus der Gruppe ausgewählt sind, die Silber, Kupfer, Gold, Titan, Chrom Tantal oder ein Gemisch dieser Metalle umfasst, und sich vorteilhafter Weise in Form von Nanopartikeln darstellen.

5. Verfahren zur Diffusion von Metallpartikeln nach einem der vorhergehenden Ansprüche, **dadurch gekennzeichnet, dass** die Verbundschicht hergestellt wird:
- durch gleichzeitige Abscheidung der Metallpartikel und der dielektrischen Matrix, oder
- durch aufeinanderfolgende Abscheidungen mindestens einer dielektrischen Matrix und von Metallpartikeln.

6. Verfahren zur Diffusion von Metallpartikeln nach einem der vorhergehenden Ansprüche, **dadurch gekennzeichnet, dass** die dielektrische Matrix eine Verbundschicht ist, die auf nassem Wege (Imprägnation, Sol-Gel) oder trockenem Wege (PVD, CVD), vorteilhafter Weise durch PVD hergestellt wird.

7. Verfahren zur Diffusion von Metallpartikeln nach einem der vorhergehenden Ansprüche, **dadurch gekennzeichnet, dass** die dielektrische Matrix ein dielektrisches Oxid, noch vorteilhafter Siliciumoxid, SiOₓ, ist.

8. Verfahren zur Diffusion von Metallpartikeln nach einem der vorhergehenden Ansprüche, **dadurch gekennzeichnet, dass** das Substrat aus Glas, Silicium oder Polymer ist.

9. Verfahren zur Diffusion von Metallpartikeln nach einem der vorhergehenden Ansprüche, **dadurch gekennzeichnet, dass** die Plasmabehandlung erfolgt:
- in einem PECVD-Reaktor,
- mit Helium,
- mit einer Frequenz zwischen 0 und 2,45 GHz, vorzugsweise zwischen 10 kHz und 450 kHz,
- über eine Dauer zwischen 1 Sekunde und 60 Minuten, vorzugsweise zwischen 15 Sekunden und 15 Minuten,
- mit einer an die Kathode angelegten Leistung zwischen 0,01 W/cm² und 10 W/cm², insbesondere zwischen 0,01 W/cm² und 1 W/cm²,
- bei einer Temperatur zwischen 15 und 45°C.

10. Verwendung eines Plasmas im Nahbereich eines Substrats, auf dem zuvor eine Verbundschicht mit eingebrachten Metallpartikeln abgeschieden wurde, um die Diffusion der Metallpartikel in Richtung auf das Substrat zu bewerkstelligen.

11. Verwendung eines Plasmas nach Anspruch 10, wobei die Verbundschicht aus einer dielektrischen Matrix besteht, in der die Metallpartikel verteilt sind.

12. Verwendung eines Plasmas nach Anspruch 10, wobei die Verbundschicht aus einer dielektrischen Matrix besteht, auf der die Metallpartikel abgeschieden sind.

## Claims

1. A method for diffusing metal particles comprised in a composite layer previously deposited on a substrate, said composite layer further comprising at least one dielectric matrix, wherein the diffusion of said metal particles towards said substrate is achieved by means of a plasma treatment.

2. The metal particle diffusion method of claim 1, **characterized in that** the plasma treatment is performed by means of a plasma called cold plasma, advantageously by means of a cold plasma at ambient temperature.

3. The metal particle diffusion method of any of claims 1 and 2, **characterized in that** the plasma contains at least one gas selected from the group comprising helium, argon, xenon, or a mixture of these gases.

4. The metal particle diffusion method of any of the foregoing claims, **characterized in that** the metal particles are particles of a metal selected from the group comprising silver, copper, gold, titanium, chromium, tantalum, or a mixture of these metals, said particles being advantageously nanoparticles.

5. The metal particle diffusion method of any of the foregoing claims, **characterized in that** the composite layer is prepared:
- by simultaneous deposition of the metal particles and of the dielectric matrix, or
- by sequential depositions of at least one dielectric matrix and of the metal particles.

6. The metal particle diffusion method of any of the foregoing claims, **characterized in that** the dielectric matrix is a composite layer prepared by wet (impregnation, sol-gel) or dry (PVD, CVD) processes, advantageously by PVD.

7. The metal particle diffusion method of any of the foregoing claims, **characterized in that** the dielectric matrix is a dielectric oxide, more advantageously silicon oxide, SiOₓ.

8. The metal particle diffusion method of any of the foregoing claims, **characterized in that** the substrate is made of glass, of silicon, or of polymer.

9. The metal particle diffusion method of any of the foregoing claims, **characterized in that** the plasma treatment is performed:
- in a PECVD reactor,
- with helium,
- with a frequency ranging between 0 and 2.45 GHz, preferably between 10 kHz and 450 kHz,
- for a time period ranging between 1 second and 60 minutes, preferably between 15 seconds and 15 minutes,
- with a power applied to the cathode ranging between 0.01 W/cm² and 10 W/cm², and in particular between 0.01 W/cm² and 1 W/cm²,
- at a temperature ranging between 15 and 45 °C.

10. A use of a plasma in the vicinity of a substrate having a composite layer integrating metal particles to achieve the diffusion of said metal particles towards the substrate.

11. The use of a plasma of claim 10, according to which the composite layer is formed of a dielectric matrix having the metal particles dispersed inside of it.

12. The use of a plasma of claim 10, according to which the composite layer is formed of a dielectric matrix having the metal particles deposited on top of it.
